# EUROPEAN PATENT APPLICATION

(11) **EP 2 336 795 A1**
(43) Date of publication of application: **22.06.2011**
(21) Application number: 09180020.1
(22) Date of filing: 18.12.2009
(51) Int. Cl.: G01R 31/327

(54) **Cable test facility for switchgear**

(71) Applicant: Eaton Industries (Netherlands) B.V., 7559 SC Hengelo (NL)
(72) Inventor: Lammers, Arend, 7558 TV Hengelo (NL); Nitert, Gerhardus, 7468 AT Enter (NL); Balm-van Tilborg, Edith, 2645 HB Hengelo (NL)
(74) Representative: Tabeling, Marcella M.J.

(57) **Abstract**

The invention provides for a medium voltage switchgear connectable to an electrical cable (6), comprising an enclosure (7) provided with a opening (3) for introducing a test electrode (24) into the enclosure (7), a cable test contact (25) which is located inside of the enclosure (7), wherein the cable test contact (25) is electrically connectable with the cable (6), and earthing means (26) for earthing the cable test contact (25) in an earthed position of the switchgear, wherein the earthing means (26) are removable from the earthed position into a test position of the switchgear in which the cable test contact (25) is disconnected from earth (32), wherein the earthing means (26) comprise a movable earthing element (26) which extends between the cable test contact (25) and the opening (3) in the enclosure (7), and wherein the earthing element (26) is hollow for receiving the test electrode (24).

## Description

### Field of the invention

The invention relates to a medium voltage switchgear connectable to an electrical cable, comprising an enclosure provided with an opening for introducing a test electrode into the enclosure, a cable test contact which is located inside of the enclosure, wherein the cable test contact is electrically connectable with the cable for performing tests.

### Background

It is generally known to equip medium voltage switchgear with a cable test facility to allow the testing of an electrical cable which is connected to the switchgear. For this reason the switchgear enclosure is provided with an opening to allow introduction of a cable test electrode. Cable testing can take place directly at the cable connectors, or through a cable test contact or bushing which is arranged near the opening in the enclosure. The test bushing is electrically connected with the electrical cable in the test position of the switchgear. The test bushing is situated behind a front cover that forms part of the enclosure and covers the cable connector compartment. Disadvantage of having test capabilities directly at or near the cable connectors is that this requires opening or removing of the isolated power cable connector.

### Description of the prior art

EP 0 054 726 and DE 41 21 764 both disclose a similar type of cable test facility for a medium voltage switchgear in which an elongated earthing element is used to connect the test bushing with earth in a service position of the switchgear. The earthing element extends inwardly from the opening in the enclosure into contact with the internal test bushing. In order to perform a cable test, the earthing element will have to be removed and the test electrode will be placed in the space previously occupied by the earthing element. Introducing the test electrode with removed earthing element could result in potentially dangerous situations unless there are provided additional earthing means.

An object of the invention is to provide a cable test facility for a medium voltage switchgear of the type mentioned in the preamble with improved safety properties and ease of use.

### Summary of the invention

The invention provides a medium voltage switchgear as set out in claim 1 is provided. The hollow earthing element allows for the introduction of the test electrode to come into contact with test contact, while the test contact is still earthed by means of the earthing element. After placing the test electrode in its place, the earthing element can be safely removed.

In a preferred embodiment of the invention, the cable test contact is located inside of the enclosure remotely from the opening and the earthing element is a tube. In this way the opening in the enclosure can be made relatively small to prevent easy access to conductive parts, such as the test contact, inside of the enclosure.

To allow ease of use, the earthing element is preferably slidable outwardly of the enclosure. After the test electrode is placed into contact with the test contact, the earthing element is simply pulled outwardly of the enclosure so that it will come out of its position in contact with the test contact.

In a further embodiment, the opening in the enclosure is closed by a gastight closure element. This will allow using the cable test facility in gas insulated switchgear in which the enclosure is filled with an insulating gas.

Furthermore, in a further embodiment, the medium voltage switchgear has a bus bar for distributing electrical energy to the cable, wherein the cable test contact is electrically connectable with the cable through a switching device and a disconnector, wherein the disconnector is a change-over switch which can be brought into contact with either the test contact or the bus bar. The disconnector can advantageously be used, on top of its normal earthing function in a disconnected position of the switchgear, as conducting part in the electric circuit for testing the electrical cable. During applying the test electrode the disconnector will also guarantee a proper earthing function since it is in contact with the test contact. Furthermore, the disconnector can be located in the upper compartment of the switchgear as a result of which also the test contact and the opening can be arranged in the upper region of the enclosure. This will provide a user easy installation of the test equipment since the opening will be on working height.

The invention is applicable to single phase as well as three phase switchgear. In the three-phase situation there is preferably provided one opening for receiving a test electrode for each phase. In this way the phases can be tested separately from each other.

The invention also provides for a method for testing an electrical cable connected to a medium voltage switchgear as set out in claim 7.

### Short description of the drawings

The above and other aspects, features and advantages of the invention will be apparent from the following detailed description of illustrative embodiments which is to be read in connection with the accompanying drawings, in which:
FIG. 1 is a side view of a three-phase medium voltage switchgear provided with a cable test facility according to en embodiment of the invention, wherein the switchgear is shown in a service position.
FIG. 2 shows the switchgear of FIG. 1 in an earthed position.
FIG. 3 shows the switchgear of FIG. 1 in a test position.
FIG. 4A-4E show schematic diagrams of the electrical circuit of the switchgear in different positions of operation.
FIG. 5 a detailed view of the cable test facility according to the invention.
FIG. 6 a front view of the switchgear of FIG. 1 with removed cover.
FIG. 7 the same view as in FIG. 6 but with a test electrode in position to perform a cable test.

### Detailed description of exemplary embodiments

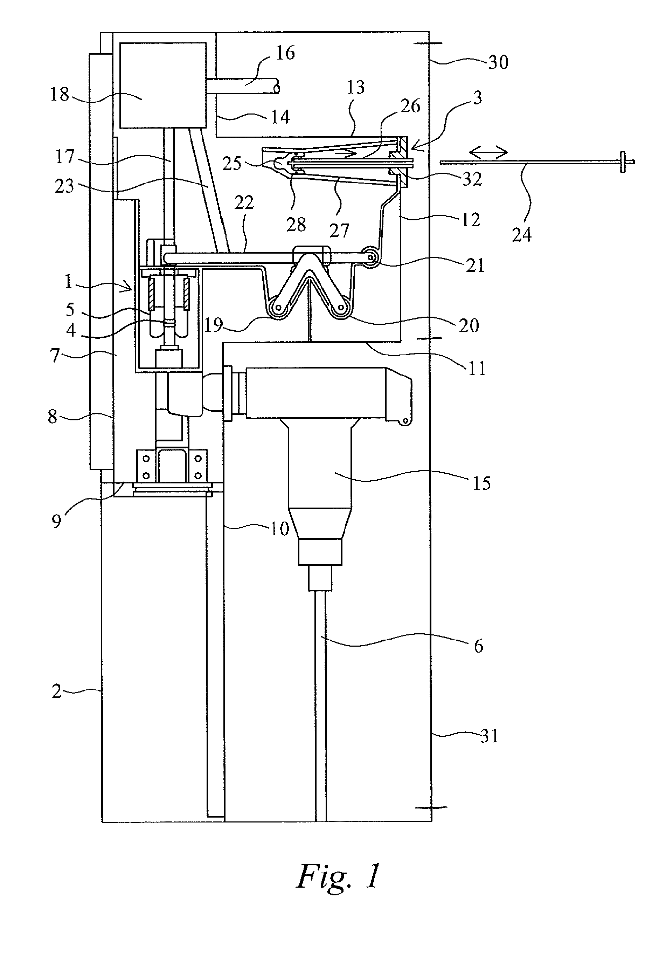

The drawings show a three-phase switchgear provided with a cable test facility according to the invention. FIG. 1 shows a side view of the switchgear in a service position. The switchgear has a housing 2 which accommodates a circuit breaker or load break switch as the main switch 1 having a fixed switch contact 4 and a movable switch contact 5. The main switch 1 is arranged in an enclosure 7 having walls 8, 9, 10, 11, 12 and 13. The fixed switch contact 4 is electrically connected through the enclosure 7 in a gastight manner to a cable connector 15.

The movable switch contact 5 is fixed on an actuator rod 17 which is coupled to an actuating mechanism 18. The actuating mechanism is driven by a drive shaft 16 protruding outwardly of the enclosure 7. A bus bar system with bus bars 19, 20 and 21 is also arranged in the enclosure 7. Bus bar 21 is connectable to the movable switch contact 5 of the main switch 1 by means of a disconnector 22. In the embodiment shown, the disconnector 22 is a change-over switch. Each of the other bus bars 19, 20 is connectable to a movable switch contact of an associated main switch by means of a further disconnector, in a similar way as bus bar 21. The disconnector 22 can be operated by the actuating mechanism 18 and a disconnector drive rode 23 extending between the drive mechanism 18 and the disconnector 22.

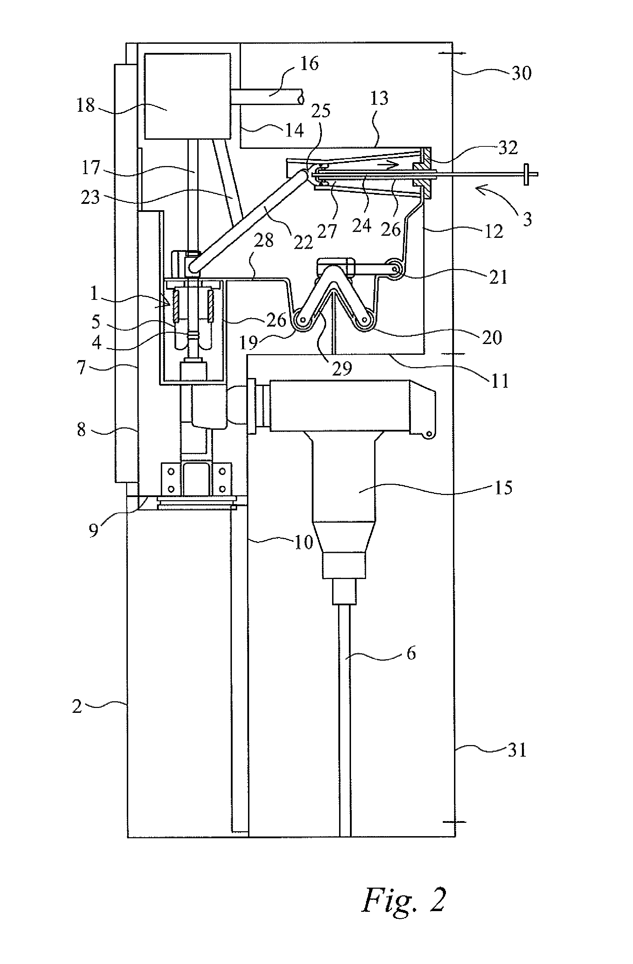

The enclosure 7 is provided with an opening 3 for introducing a test electrode 24 into the enclosure 7. A cable test contact 25 is located inside of the enclosure 7 remotely from the opening 3. This cable test contact 25 is electrically connectable with a cable 6. Furthermore, the switchgear is provided with an earthing element 26 which extends between the cable test contact 25 and the opening 3 in the enclosure 7. An earth strip 32 is arranged in the opening 3. The earth strip 32 is connected to earth via the enclosure 7. The earthing element 26 can be moved outwardly from the position as shown in Fig 1 into the position as shown in FIG. 2 while it slides in the earth strip 32. The earthing element 26 is hollow and has a tube-like form for receiving the test electrode 24.

In the embodiment of the switchgear as shown in FIG. 1-3, the enclosure 7 is filled with an insulating gas, e.g. air or SF6. The drive shaft 16 of the actuating mechanism 18 for the main switch 1 and the disconnector 22 protrudes through the wall 14 of the enclosure 7 in a gastight manner. The opening 3 in the enclosure 7 is closed by a closure element 27. The closure element 27 surrounds the cable test contact 25 in which a gastight seal 28 is arranged between the contact 25 and the closure element 27. A further gastight seal 33 is arranged between the closure element 27 and the enclosure wall12. The closure element 27 is preferably made of a gastight, electrically insulating material.

The housing of the switchgear 2 is provided with an upper and lower panel door 30, 31 to provide access to the test facility and cable connection respectively.

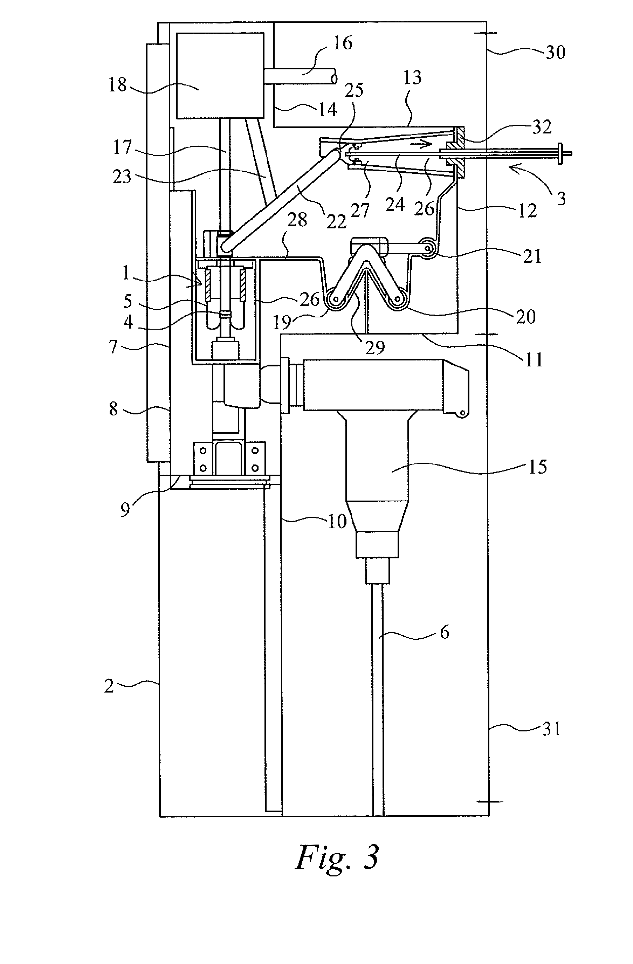

The switchgear shown in FIG. 1 is in the service position with the main switch 1 closed and the disconnector 22 in the bus bar position. FIG. 2 shows the earthed position of the switchgear with the disconnector 22 in contact with earth. It is this contact for earthing that will be used as cable test contact 25 for performing a cable test. The test is performed over the disconnector 22, via main switch 1 to the cable 6. In the earthed position of FIG. 2, the earthing element 26 keeps the cable test contact 25 linked to earth, via earth strip 32 and the enclosure 7. In this earthed position, the test electrode 24 can be inserted in the hole of the earthing element 26 until it comes into contact with the cable test contact 25. It is only then, that the earthing element 26 can be removed by pulling it out of the enclosure 7. The earthing element 26 can either be removed completely, i.e. separated from the enclosure 7, or maintains to be connected to the enclosure 7 so that it will not get lost. FIG. 3 shows the thus obtained test position. In this position, a test voltage can be applied to the cable 6 since there is a closed electrical connection between the test electrode and the cable over disconnector 22 and the main switch 1.

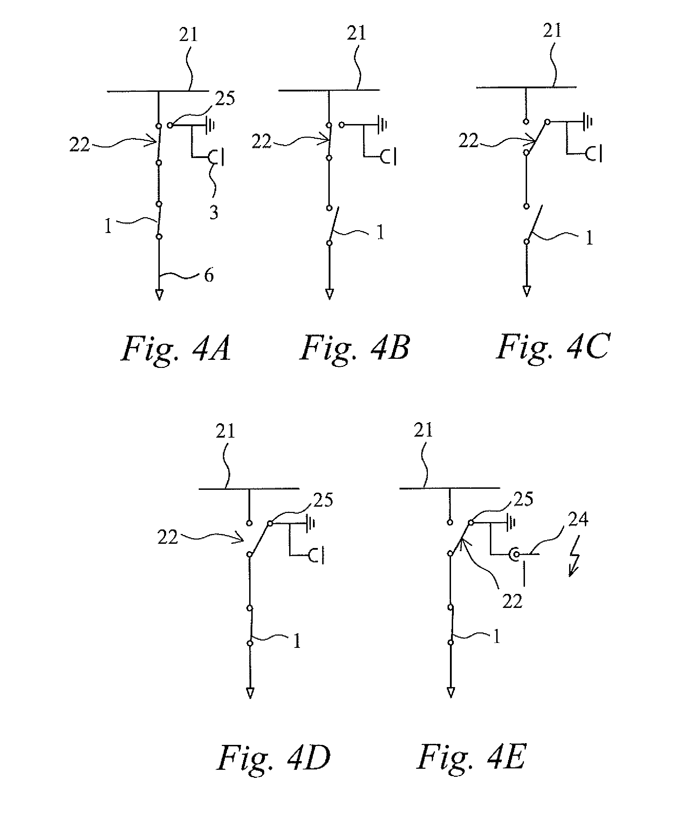

FIGS. 4A-4E show schematically the electrical circuit of the switchgear according to the invention. FIG. 4A represents the service position; FIG. 4B the open position; FIG. 4C the disconnected position; FIG. 4D the earthed position and finally FIG. 4E shows the test position. In order to test an electrical cable 6 connected to a medium voltage switchgear according to the invention, the switchgear will be brought from its service position to its test position following the steps as shown in FIG. 4A-4E. Hence, first the main switch 1 will be opened, then the disconnector will be brought from its bus bar position into its earthed position, after which the main switch 1 can be closed again. While the cable 6 is linked to earth (FIG. 4E) the test opening is opened, the test electrode is inserted into the earthing element, the earthing element is removed and the test voltage is applied. This test position is represented in FIG. 4E. After testing the steps are followed in reverse order: remount earthing element, remove the test electrode, open the main switch 1, bring the disconnector 22 in contact again with the bus bar (FIG. 4B) and close the main switch 1 to bring the switchgear back in service.

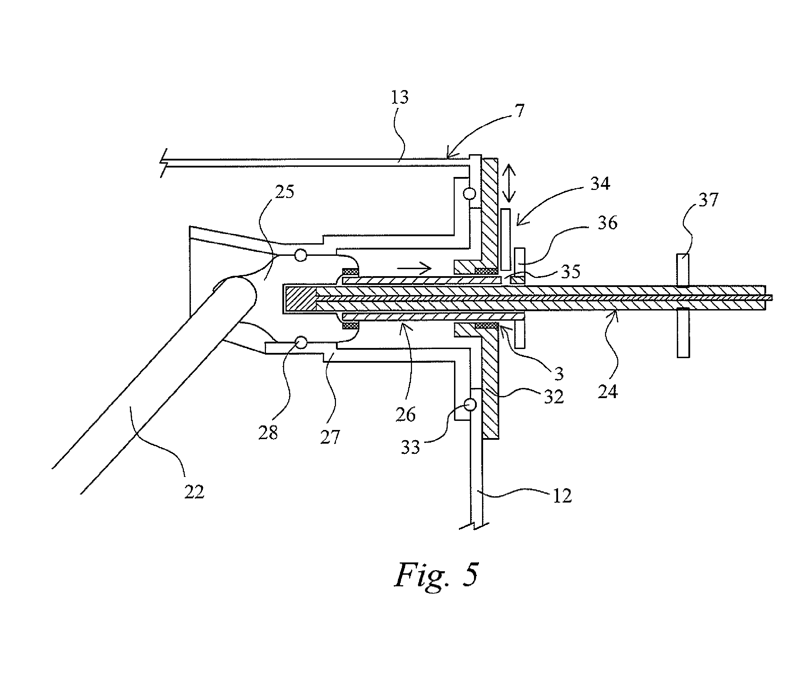

FIG. 5 shows the cable test facility of the switchgear shown in FIG. 1-3 in more detail. This detailed view clearly shows how the test electrode 24 is in contact with the test contact 25 while the test contact is still earthed by means of earthing element 26. In this earthed position, the disconnector 22 is also in contact with the test or earth contact 25. The earthing element 26 is provided with a recess 35 at its outer end. Furthermore, a locking plate 34 is movably arranged at the front side of the enclosure 7. The locking plate 34 and the recess 35 in the earthing element 26 together provide a locking mechanism for locking the earthing element 26 in contact with the test contact 25 as long as the switchgear is not in its earthed position.

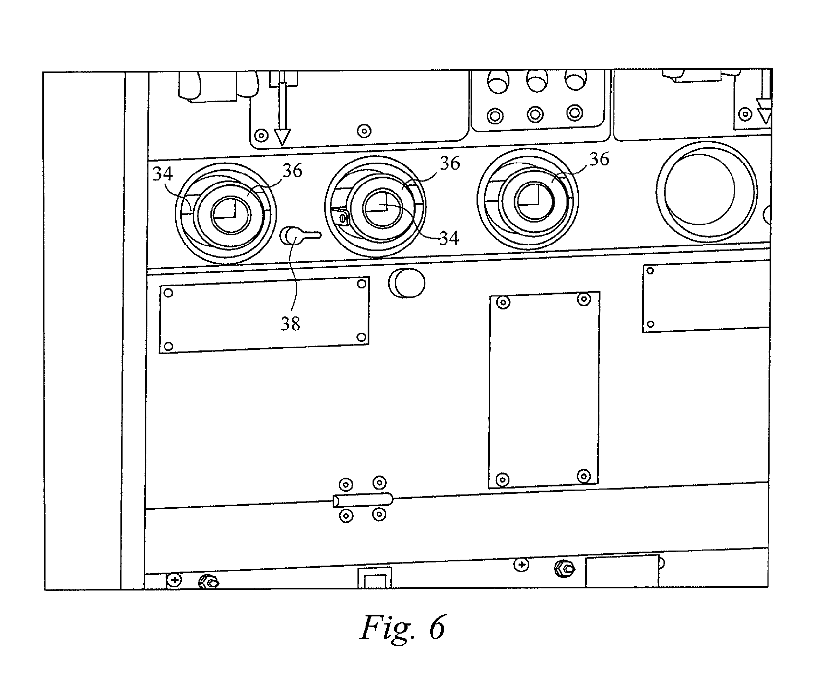

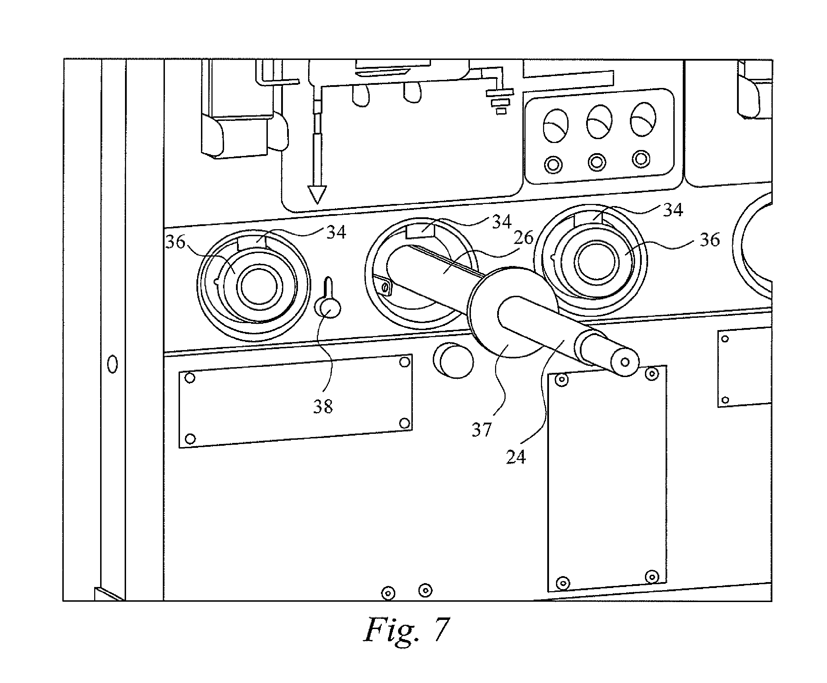

FIGS. 6 and 7 show the front side of the switchgear with the cover 30 removed.
The openings 3 are visible as well as the earthing elements 26 that are arranged in the openings 3. Each earthing element 26 is provided with a disc-shaped outer end 36 for pulling the earthing element 26 out of the enclosure 7. The locking mechanism further comprises a control device 38 which is linked with the locking plate 34 for moving it from its locked position into its unlocked position, and vice versa. The control device 38 is also linked with the disconnector 22 and the main switch 1 to determine if these switches are respectively in their correct position, which will be explained below. The control device 38 is preferably mechanically linked with, on the one hand, the locking plate 34, and on the other hand the disconnector 22 and the main switch 1.

FIG. 6 shows the earthing elements 26 in their locked positions. In these positions, the locking plates 34 are in their lowest position, i.e. located in the recess 35. This prevents the removal of the earthing element 26 but also the insertion of the test electrode 24 since the locking plate is blocking the hole in the earthing element 26. Only when the main switch 1 is in the closed position and the disconnector 22 is in the earthed position (and thus the switchgear in its earthed position), the control device 38 can be activated (e.g. rotated) to remove the locking plate 34 out of the recess 35 and to allow the insertion of the test electrode 25 and the removal of the earthing element 26. This position is shown in FIG. 7. The test electrode 25 is inserted. The earthing element 26 is pulled out until its outer end 36 comes into abutment with a disc-shaped extension 37 on the test electrode 25. The cable test facility is ready for testing.

## Claims

1. A medium voltage switchgear connectable to an electrical cable, comprising:
- an enclosure provided with a opening for introducing a test electrode into the enclosure,
- a cable test contact which is located inside of the enclosure, wherein the cable test contact is electrically connectable with the cable, and
- earthing means for earthing the cable test contact in an earthed position of the switchgear,
- wherein the earthing means are removable from the earthed position into a test position of the switchgear in which the cable test contact is disconnected from earth,
- wherein the earthing means comprise a movable earthing element which extends between the cable test contact and the opening in the enclosure, and
- wherein the earthing element is hollow for receiving the test electrode.

2. The medium voltage switchgear according to claim 1, wherein the cable test contact is located inside of the enclosure remotely from the opening and wherein the earthing element is a tube.

3. The medium voltage switchgear according to claim 1 or 2, wherein the earthing element is slidable outwardly of the enclosure.

4. The medium voltage switchgear according to any of the claims 1-3, wherein the opening in the enclosure is closed by a gastight closure element.

5. The medium voltage switchgear according to any of the claims 1-4 having a bus bar for distributing electrical energy to the cable, wherein the cable test contact is electrically connectable with the cable through a switching device and a disconnector, wherein the disconnector is a change-over switch which can be brought into contact with either the test contact or the bus bar.

6. The medium voltage switchgear according to any of the claims 1-5, wherein the switchgear is a three-phase switchgear, wherein there is provided an opening for receiving a test electrode for each phase.

7. The medium voltage switchgear according to any of the claims 1-6, further comprising a locking mechanism for locking the earthing element in contact with the test contact as long as the switchgear is not in its earthed position, wherein the locking mechanism comprises a locking plate which corporates with a recess in the earthing element.

8. Method for testing an electrical cable connected to a medium voltage switchgear according to claim 1, comprising:
- introducing the test electrode through the opening in the enclosure until it is in electrical contact with the cable test contact which is electrically connected with the cable to be tested, and
- applying a test voltage to the test electrode,
- wherein the test electrode is brought into electrical contact with the cable test contact by inserting the test electrode in the hollow earthing element,
- and after bringing the test electrode into electrical contact with the cable test contact moving the hollow earthing element outwardly to disconnect the cable test contact from earth after which the test voltage is applied to the test electrode.
